# EUROPEAN PATENT APPLICATION

(11) **EP 2 610 627 A1**
(43) Date of publication of application: **03.07.2013**
(21) Application number: 12197828.2
(22) Date of filing: 18.12.2012
(51) Int. Cl.: G01R 15/20

(54) **Current sensor**

(30) Priority: 28.12.2011 JP 2011287189; 18.04.2012 JP 2012094732; 11.10.2012 JP 2012226461
(71) Applicant: TDK Corporation, Tokyo 103-8272 (JP)
(72) Inventor: Miyakoshi, Takaaki, Tokyo, 103-8272 (JP); Kashiwagi, Takao, Tokyo, 103-8272 (JP); Hirano, Hiroyuki, Tokyo, 103-8272 (JP); Fukuoka, Seiji, Tokyo, 103-8272 (JP)
(74) Representative: Epping - Hermann - Fischer

(57) **Abstract**

A current sensor has first (30A) and second magnetic bodies (30B) for magnetic shielding opposed to each other, and a bus bar (10) and a Hall IC (20) disposed between the magnetic bodies. The magnetic bodies are magnetized in directions opposite to each other when a current flows through the bus bar, and the Hall IC is disposed at a position at which a magnetic field applied to the Hall IC is weakened by a magnetic field generated by magnetization of the first magnetic body and a magnetic field generated by magnetization of the second magnetic body.

## Description

### BACKGROUND OF THE INVENTION

### 1. Field of the Invention

The present invention relates to a current sensor measuring a battery current, a motor drive current of a hybrid car or an electric vehicle, for example, and particularly to a current sensor measuring a current flowing through a bus bar by using a magnetic sensitive element such as a Hall element.

### 2. Description of the Related Art

A magnetic proportional type current sensor having a ring-shaped magnetic core with an air gap and a magnetic sensitive element disposed in the air gap has hitherto been known as a current sensor detecting a current (measured current) flowing through a bus bar in a noncontact state by using a magnetic sensitive element such as a Hall element. Recent motors for hybrid cars and electric vehicles are driven by three-phase AC current having phases shifted by 120 degrees from each other. Therefore, three bus bars for a three-phase AC power source (U-phase, V-phase, and W-phase) are used for electric connection to the outside. Because of demand for miniaturizing a device, a pitch between the bus bars is required to be further reduced and the miniaturization of a current sensor is accordingly required.

Since a coreless current sensor as described in Japanese Laid-open Patent Publication No. 2010-127896 is prone to deterioration of current detection accuracy due to the effect of a magnetic field from the outside, a magnetic body is disposed to surround a magnetic sensitive element and a bus bar for magnetic shielding.

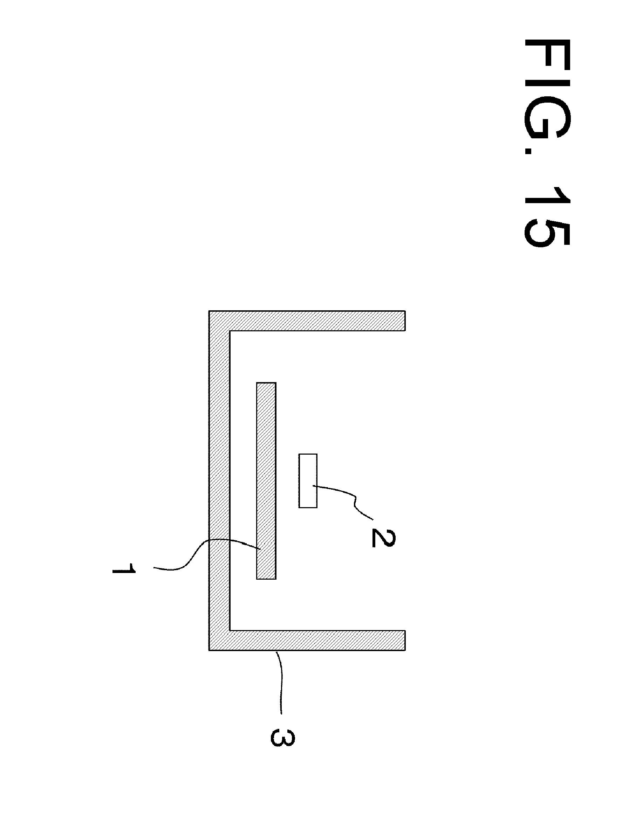

FIG. 15 shows a conventional example of a coreless current sensor of this type (corresponding to a structure disclosed in Japanese Laid-Open Patent Publication No. 2010-127896) and the coreless current sensor has a bus bar 1 that is a conductor through which a measured current flows, a magnetic sensitive element 2 fixedly disposed on the bus bar 1 such that a magnetic field generated by the current of the bus bar 1 is applied to a magnetic sensitive surface of the element 2, and a U-shaped cross-sectional magnetic body 3 magnetically shielding the magnetic sensitive element 2. In this case, the U-shaped cross-sectional magnetic body 3 surrounds the bottom surfaces and the both side surfaces of the magnetic sensitive element 2 and a bus bar portion on which the sensitive element 2 is mounted.

Since the coreless current sensor is equipped with the magnetic body for magnetic shielding and the magnetic body has hysteresis characteristics to no small extent, the magnetic field detected by the magnetic sensitive element includes a residual magnetic field caused by the hysteresis characteristics of the magnetic body. For instance, after the measured current has flowed through the bus bar, a residual magnetic field due to the magnetic body remains even if the current of the bus bar turns to zero amperes. Therefore, it causes a problem of reduction in measurement accuracy when no current flows through the bus bar (when the current is zero amperes). No countermeasure against the effect of the residual magnetic field caused by hysteresis of the magnetic body for magnetic shielding is described in the conventional examples.

### SUMMARY OF THE INVENTION

The present invention was conceived in view of the situations and it is therefore an object of the present invention to provide a current sensor capable of reducing occurrence of measurement errors when no current flows through a bus bar (when the current is zero amperes) and achieving improvement in measurement accuracy.

An embodiment of the present invention is a current sensor. The current sensor comprises first and second magnetic bodies for magnetic shielding opposed to each other; and a bus bar and a magnetic sensitive element disposed between the first and second magnetic bodies, wherein the first and second magnetic bodies are magnetized in directions opposite to each other when a current flows through the bus bar, and wherein the magnetic sensitive element is disposed at a position at which a magnetic field applied to the magnetic sensitive element is weakened by a magnetic field generated by magnetization of the first magnetic body and a magnetic field generated by magnetization of the second magnetic body.

In the current sensor according to the embodiment, coercive forces of the first and second magnetic bodies may be equivalent or close to each other.

In the current sensor according to the embodiment, cross sections of the first and second magnetic bodies may have the same or similar shapes.

In the current sensor according to the embodiment, cross sections of the first and second magnetic bodies may have asymmetrical shapes.

In the current sensor according to the embodiment, the embodiment may include a configuration in which the both end edges of the first and second magnetic bodies are opposed to each other via respective gaps, the first and second magnetic bodies surround the bus bar and the magnetic sensitive element inside as a whole, and the magnetic sensitive element is located between a first straight line connecting the both end edges of the first magnetic body and a second straight line connecting the both end edges of the second magnetic body or located on the first or second straight line.

In the current sensor according to the embodiment, a magnetic sensitive surface of the magnetic sensitive element may be located between the first straight line and the second straight line.

In the current sensor according to the embodiment, a magnetic sensitive surface of the magnetic sensitive element may be located on, or in the vicinity of, a straight line connecting midpoints of a gap length at the both end edges of the first and second magnetic bodies.

In the current sensor according to the embodiment, the embodiment may include a configuration in which the bus bar is in a flat-plate shape having a wide principal surface that is parallel to the straight line and the magnetic sensitive element is fixedly disposed on the wide principal surface.

In the current sensor according to the embodiment, each of the first and second magnetic bodies may be disposed with an opening hole containing an intersection point between the first and second magnetic bodies and a line that is substantially perpendicular to a plane passing through the gaps at the both end edges of the first and second magnetic bodies and that passes through the magnetic sensitive element.

In the current sensor according to the embodiment, a cutout portion may be disposed in each of intermediate portions of the both end edges of the first and second magnetic bodies opposed to each other through the gaps.

In the current sensor according to the embodiment, the embodiment may include a configuration in which the both end edges of the first and second magnetic bodies are opposed to each other, the first and second magnetic bodies surround the bus bar and the magnetic sensitive element inside as a whole, and the magnetic sensitive element is located on a straight line connecting the opposed surfaces of the both end edges of the first magnetic body and the both end edges of the second magnetic body. In this case, a magnetic sensitive surface of the magnetic sensitive element may be located on, or in the vicinity of, a straight line connecting the opposed surfaces of the both end edges of the first and second magnetic bodies. The bus bar may be in a flat-plate shape having a wide principal surface that is parallel to the straight line, and the magnetic sensitive element is fixedly disposed on the wide principal surface. Each of the first and second magnetic bodies may be disposed with an opening hole containing an intersection point between the first and second magnetic bodies and a line that is substantially perpendicular to a plane passing through the opposed surfaces of the both end edges of the first and second magnetic bodies and that passes through the magnetic sensitive element. Also, a cutout portion may be disposed in each of intermediate portions of the both end edges of the first and second magnetic bodies opposed to each other.

In the current sensor according to the embodiment, the shape of the magnetic bodies may be a half rectangular tube shape, a half elliptic tube shape, a half cylindrical shape, or a half oval shape.

In the current sensor according to the embodiment, the current sensor may be disposed with a feedback coil generating a magnetic field canceling a generated magnetic field due to a current of the bus bar.

It is to be noted that any arbitrary combination of the above-described structural components as well as the expressions according to the present invention changed among a system and so forth are all effective as and encompassed by the present embodiments.

According to the embodiments, it is able to reduce current measurement errors caused by the hysteresis characteristics of the magnetic body used for magnetic shielding of the magnetic sensitive element and to achieve improvement in measurement accuracy when the bus bar carries no current or near zero amperes. Since the residual magnetic field caused by the hysteresis can be reduced regardless of a coercive force specific to magnetic material, excellent current detection characteristics can be implemented with inexpensive magnetic material and cost can be reduced.

### BRIEF DESCRIPTION OF THE DRAWINGS

Embodiments will now be described, by way of example only, with reference to the accompanying drawings which are meant to be exemplary, not limiting, and wherein like elements are numbered alike in several figures, the drawings in which:

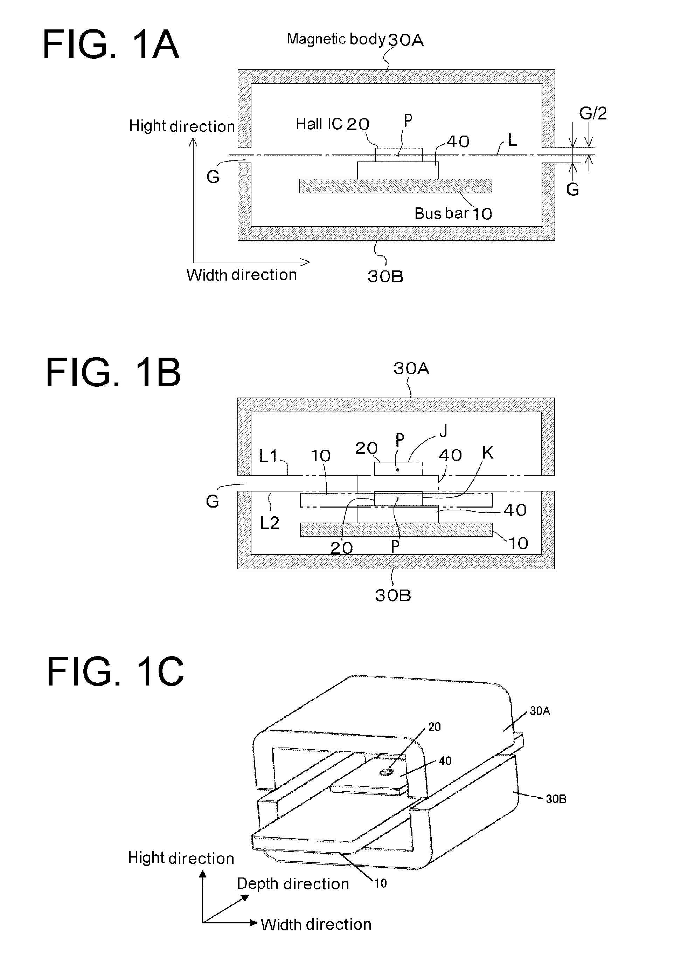

FIG. 1A to FIG. 1C show a first embodiment of a current sensor according to the present invention; FIG. 1A is a front cross-sectional view when a magnetic sensitive surface of a Hall IC acting as a magnetic sensitive element is located on a straight line connecting midpoints of an air gap length at both end edges of first and second magnetic bodies for magnetic shielding; FIG. 1B is a front cross-sectional view of an upper limit position when the Hall IC is located on a first straight line connecting the both end edges of the first magnetic body or a lower limit position when the Hall IC is located on a second straight line connecting the both end edges of the second magnetic body; and FIG. 1C is a perspective view of the first embodiment;
FIG. 2A to FIG. 2C are views for explaining magnetization when a bus bar carries a current and a residual magnetic field generated in the magnetic bodies for magnetic shielding; FIG. 2A is an explanatory view of the magnetization when the bus bar carries a current in the first embodiment; FIG. 2B is an explanatory view of the residual magnetic field when the current flow of the bus bar is stopped in the first embodiment; and FIG. 2C is an explanatory view of a residual magnetic field in the case of a conventional example;
FIG. 3 is an explanatory view when the bus bar and the Hall IC are moved from the lower side to the upper side in the first and second magnetic bodies for magnetic shielding so as to acquire a graph of FIG. 4;
FIG. 4 is a graph of relationship between a position deviation (distance) (mm) from the straight line to the magnetic sensitive surface of the Hall IC and the residual magnetic field (mT) due to hysteresis, where the straight line connects the midpoints of the air gap length at the both end edges of the first and second magnetic bodies;
FIG. 5 is a plan view of a second embodiment of a current sensor according to the present invention;
FIG. 6 is a side view of a third embodiment of a current sensor according to the present invention;
FIG. 7A to FIG. 7D show the presence of a positional shift between the first and second magnetic bodies in the embodiments and FIGS. 7A, 7B, 7C, and 7D are front cross-sectional views when no positional shift exists, when the first magnetic body is positionally shifted upward, when the first magnetic body is positionally shifted to the right, and when the first magnetic body is positionally shifted to the left, respectively;
FIG. 8A to FIG. 8C show that the presence of a positional shift varies a generated magnetic field (mT) at the position of the magnetic sensitive surface of the Hall IC acting as a magnetic sensitive element in the embodiments and FIGS. 8A, 8B, and 8C are explanatory views (tables) in the case of the first embodiment, in the case of the second embodiment, and in the case of the third embodiment, respectively;

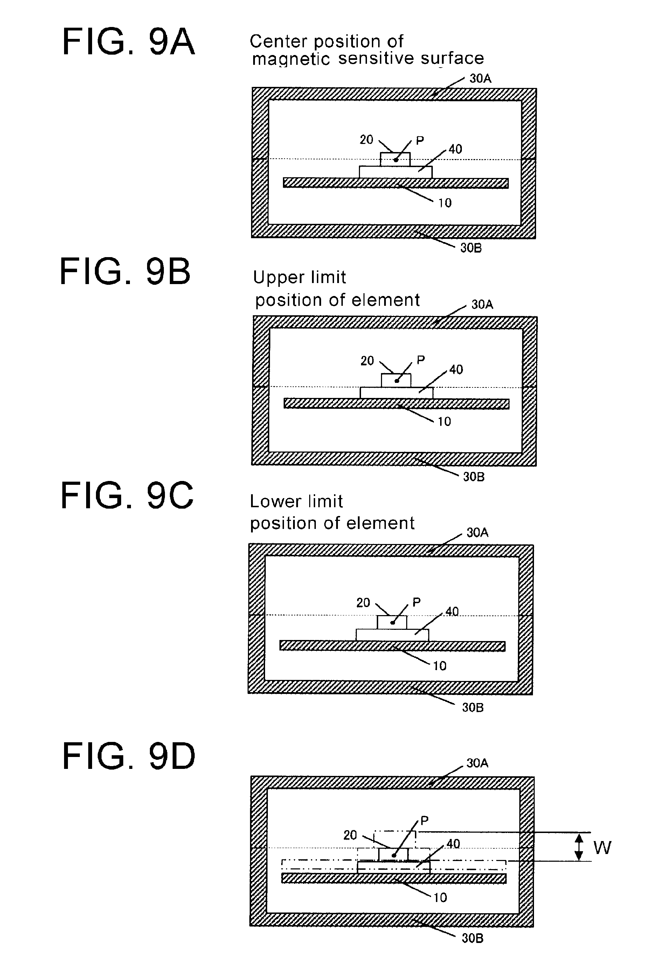

FIG. 9A to FIG. 9D are front cross-sectional views of a fourth embodiment of a current sensor according to the present invention; FIG. 9A is a front cross-sectional view when the magnetic sensitive surface of the Hall IC acting as the magnetic sensitive element is located on a straight line connecting the opposed surfaces at both end edges of the first and second magnetic bodies for magnetic shielding; FIG. 9B is a front cross-sectional view of an upper limit position when the Hall IC is located on the straight line connecting the opposed surfaces at both end edges of the first and second magnetic bodies; FIG. 9C is a front cross-sectional view of the lower limit; and FIG. 9D is a front cross-sectional view of a preferable disposition range W of a Hall IC 20 in which the residual magnetic field is reduced;
FIG. 10 is a perspective view of a fifth embodiment of a current sensor according to the present invention, showing a magnetic balance type configuration;
FIG. 11 is a schematic plan view of an internal configuration of an MR element bridge with feedback coil in the fifth embodiment;
FIG. 12 is a cross-sectional view taken along a-a' of FIG. 11;
FIG. 13 is a circuit diagram of the fifth embodiment;
FIG. 14A to FIG. 14E show modifications of the magnetic bodies for magnetic shield and the bus bar, and FIGS. 14A, 14B, 14C, 14D, and 14E are explanatory views (front cross-sectional views) when the magnetic bodies have a half elliptic shape, when the magnetic bodies have a half cylindrical shape, when the magnetic bodies have a half oval shape, when the magnetic bodies have different cross sections, and when the bus bar has a substantially semicircular column shape, respectively; and
FIG. 15 is a front cross-sectional view of a conventional example.

### DESCRIPTION OF THE PREFERRED EMBODIMENTS

The invention will now be described based on the following embodiments which do not intend to limit the scope of the present invention but exemplify the invention. The same or equivalent constituent elements, members, processes, etc., shown in the drawings are denoted by the same reference numerals and redundant description will be omitted arbitrarily. All of the features and the combinations thereof described in the embodiments are not necessarily essential to the invention.

FIG. 1A to 1C show a first embodiment of a current sensor according to the present invention and the current sensor has a bus bar (current conducting member) 10 that is a conductor through which a measured current flows, a Hall IC 20 acting as a magnetic sensitive element fixedly disposed via an insulating substrate 40 on the bus bar 10, and a pair of first and second U-shaped cross-sectional magnetic bodies 30A and 30B magnetically shielding the Hall IC 20. The both end edges of the pair of the first and second U-shaped cross-sectional magnetic bodies 30A and 30B are opposed to each other with respective air gaps (magnetic gaps) G therebetween. In FIG. 1A, the height direction and the width direction are defined by arrows.

The bus bar 10 is in a flat-plate shape (e.g., a cupper plate) and the Hall IC 20 is fixedly disposed via the insulating substrate 40 on a wide principal surface of the bus bar 10 such that a magnetic field generated by a current flowing through the bus bar 10 (magnetic field circling around the bus bar) is applied to a magnetic sensitive surface P (magnetic sensitive surface of a Hall element built into the Hall IC 20) . The Hall IC 20 is mounted on and fixed to the insulating substrate 40. The Hall IC 20 is located in the middle in the width direction of the bus bar 10 and the magnetic sensitive surface P thereof is preferably located at substantially the center in the width direction of the bus bar and is substantially perpendicular to the width direction (the magnetic sensitive direction is the width direction of the bus bar 10) . In this case, the magnetic field generated by the bus bar current is substantially perpendicular to the magnetic sensitive surface of the Hall IC 20.

The U-shaped cross-sectional magnetic bodies 30A and 30B for magnetic shielding have a shape of a rectangular tube divided in half by forming respective air gaps G in two side surfaces, i.e., each of the magnetic bodies 30A and 30B has a half rectangular tube shape. The magnetic bodies 30A and 30B are formed by folding high-permeability magnetic material (e.g., silicon steel sheets) into a U-shaped cross section, have the same outer shape, and are opposed to each other with a predetermined air gap length (a length of the air gap G in the height direction). The pair of the U-shaped cross-sectional magnetic bodies 30A and 30B generally surrounds the Hall IC 20 and a bus bar portion on which the Hall IC 20 is disposed inside so as to achieve magnetic shielding from the external magnetic field.

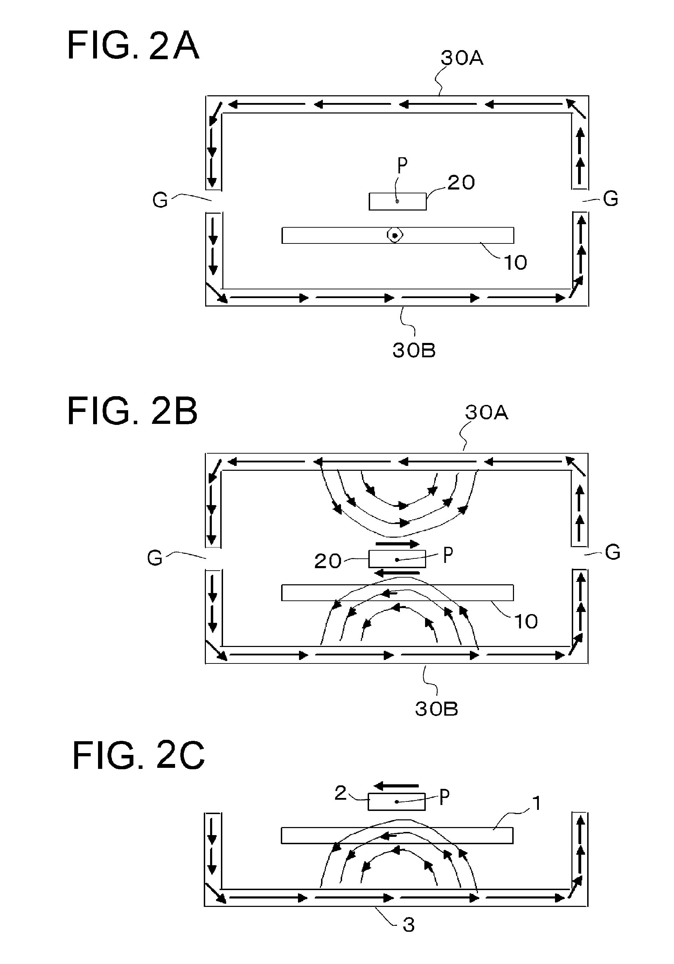

The current flow through the bus bar 10 generates a magnetic flux circling around the bus bar 10 and the flux partly flows through the magnetic bodies 30A and 30B for magnetic shielding, causing magnetization in the direction of arrows of FIG. 2A. Even when the bus bar 10 turns to no current state, residual magnetization remains in the magnetic bodies 30A and 30B due to hysteresis characteristics and the residual magnetization causes a residual magnetic field in the space surrounded by the magnetic bodies 30A and 30B as shown in FIG. 2B. FIG. 2B shows the direction (magnetic line) of the magnetic flux caused by the remaining magnetization of the magnetic body 30A and the direction (magnetic line) of the magnetic flux caused by the remaining magnetization of the magnetic body 30B.

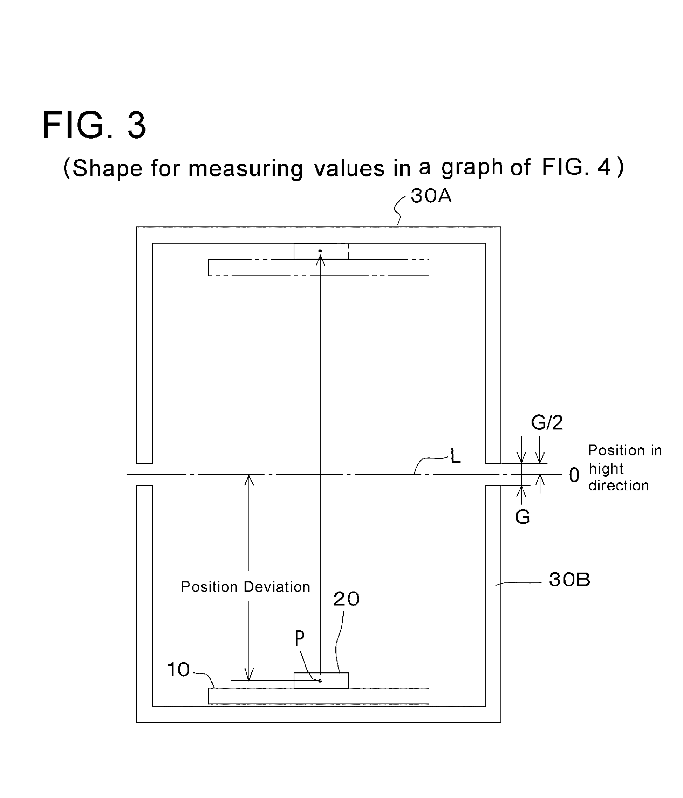

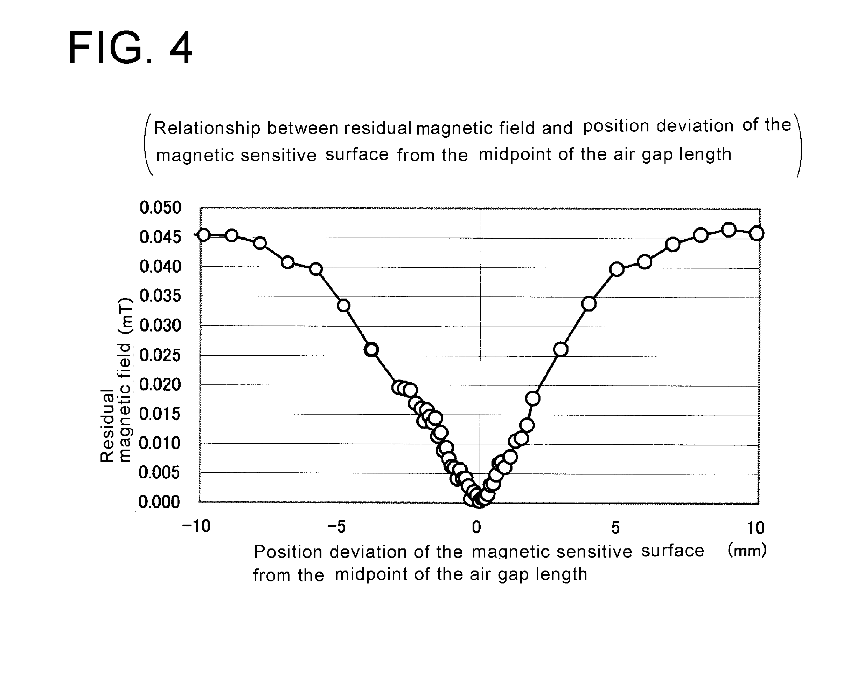

In this embodiment, to eliminate or reduce the effect of the residual magnetic field due to the magnetic bodies 30A and 30B, as shown in FIG. 1A, the position of the magnetic sensitive surface P of the Hall IC 20 is set to be located on a straight line L connecting midpoints of the air gap length at both end edges of the magnetic bodies 30A and 30B. The positions of the bus bar 10 and the magnetic sensitive surface P of the Hall IC 20 in the width direction of the magnetic bodies 30A and 30B are set such that the bus bar 10 and the magnetic sensitive surface P are located at, or in the vicinity of, the center in the width direction of the magnetic bodies 30A and 30B. In the arrangement of FIG. 1A, as can be seen from FIG. 2B, the magnetic field generated by magnetization of the magnetic body 30A and the magnetic field generated by magnetization of the magnetic body 30B are canceled each other at the position of the magnetic sensitive surface P and, as described later in FIGS. 3 and 4, it is found out that the arrangement is least affected by the residual magnetic field. It is obvious that the effect of the residual magnetic field can sufficiently be reduced in the vicinity of the arrangement of FIG. 1A. If the height direction, the depth direction, and the width direction are defined as shown in FIG. 1C, the effect of the residual magnetic field can be reduced by equalizing the depth dimensions of the magnetic body 30A and the magnetic body 30B and equalizing the thickness dimensions of the magnetic body 30A and the magnetic body 30B.

Even if it is difficult to accurately estimate the position of the magnetic sensitive surface P of the Hall IC 20 from the outer shape of the Hall IC 20, the same effect can be acquired by disposing the Hall IC 20 on the assumption that the magnetic sensitive surface P exists at the height position corresponding to 1/2 of the thickness dimension of the Hall IC 20. The size of the magnetic sensitive surface of the Hall IC 20 is sufficiently small as compared to the length in the height direction of the air gap G and, therefore, the size of the magnetic sensitive surface can be ignored and considered as one point P.

FIG. 1B shows arrangement of an embodiment pursuant to FIG. 1A, indicating a disposition range of the bus bar 10 and the Hall IC 20 capable of sufficiently suppressing the effect of the residual magnetic field. In this case, the Hall IC 20 (outer shape) is located between a first straight line L1 connecting the both end edges of the magnetic body 30A and a second straight line L2 connecting the both end edges of the magnetic body 30B or is located on the first or second straight line L1, L2 (including the case that the outer shape line of the Hall IC 20 is on the straight line L1, L2 as indicated by outer shape lines J, K). Even in the disposition range of the Hall IC 20 shown in FIG. 1B, as can be seen from FIG. 2B, the magnetic field generated by magnetization of the magnetic body 30A and the magnetic field generated by magnetization of the magnetic body 30B are directed to cancel each other and, therefore, the Hall IC 20 is disposed within a range in which the residual magnetic field is reduced.

The position of the magnetic sensitive surface P of the Hall IC 20 is more preferably located between the first straight line L1 and the second straight line L2.

In the case of the conventional example, as shown in FIG. 2C, the magnetic sensitive element 2 detects a unidirectional residual magnetic field caused by the magnetic body 3.

FIG. 3 explains the case that the bus bar 10 and the Hall IC 20 are moved from the lower side to the upper side in the first and second magnetic bodies 30A and 30B for magnetic shielding so as to acquire numeric values of a graph of FIG. 4 representative of the residual magnetic field in the first embodiment. The positions of the bus bar 10 and the magnetic sensitive surface P of the Hall IC 20 in the width direction of the magnetic bodies 30A and 30B are set such that the bus bar 10 and the magnetic sensitive surface P are located at the center in the width direction of the magnetic bodies 30A and 30B. In FIG. 3, the position of the magnetic sensitive surface P of the Hall IC 20 (assumed to be at the height position corresponding to 1/2 of the outer shape height of the Hall IC 20 in this case) is moved from -10 mm to +10 mm on the basis of the straight line L passing through the midpoints of the air gap length (length in the height direction of the air gap G), so that a residual magnetic field is measured at each position deviation from the line L resulting in the graph of FIG. 4, when the bus bar 10 is turned to be no current state after the bus bar 10 has carried a current at 300 amperes.

As can be seen form the graph of FIG. 4, the residual magnetic field is the lowest when the magnetic sensitive surface P is located on the straight line L passing through the midpoints of the air gap length as in the arrangement of FIG. 1A and, even in the disposition range of FIG. 1B (the position of the magnetic sensitive surface P is within ±1.5 mm relative to the straight line L), a reduction effect of 50 % or more can be acquired as compared to arrangement without consideration to the residual magnetic field.

According to the embodiment, the following effects can be obtained.

(1) The effect of the residual magnetic field caused by magnetization of the first and second magnetic bodies 30A and 30B for magnetic shielding during current flowing through the bus bar 10 can be eliminated or reduced, and the hysteresis of detected output of the current sensor can be turned to zero (or near zero) in principle. Therefore, the zero-ampere measurement accuracy of the current sensor can be improved.

(2) Since the hysteresis of detected output of the current sensor can be reduced regardless of a coercive force (hysteresis characteristics) specific to magnetic material used for the first and second magnetic bodies 30A and 30B for magnetic shielding, excellent detection characteristics of the current sensor can be implemented with inexpensive magnetic material and cost reduction can be achieved.

(3) Due to the structure having the first and second magnetic bodies 30A and 30B opposed to each other, a magnetic flux flowing into the magnetic sensitive element, i.e., a magnetic field applied to the magnetic sensitive element, is reduced as compared to a structure using one magnetic body for magnetic shielding as in the conventional example and, therefore, a current can be measured in a wider range.

(4) To measure a current in a wider range with a structure using one magnetic body for magnetic shielding as in the conventional example, a dimension in the width direction of the magnetic body for magnetic shielding must be increased to reduce the magnetic flux flowing into the magnetic sensitive element; however, since the magnetic flux flowing into the magnetic sensitive element can be suppressed by facing the first and second magnetic bodies 30A and 30B to each other in the embodiment, even when a large current is measured, a dimension in the width direction of each of the magnetic bodies for magnetic shielding may be made smaller and the current sensor can be reduced in size.

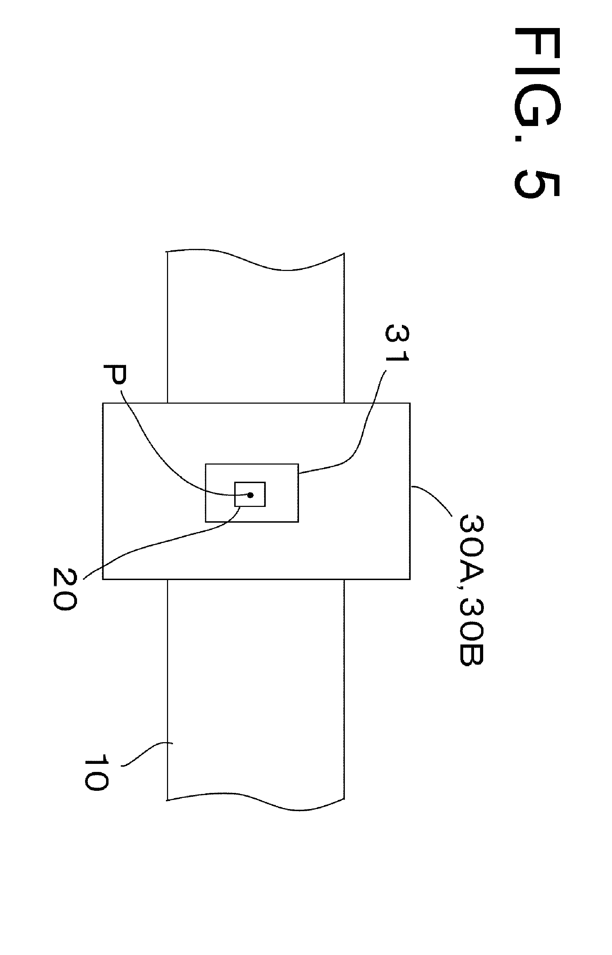

FIG. 5 shows a second embodiment of the present invention. In this case, the positional relationship of the bas bar 10, the Hall IC 20 acting as a magnetic sensitive element, and the first and second U-shaped cross-sectional magnetic bodies 30A and 30B is the same as the first embodiment; however, each of top surfaces of the first and second magnetic bodies 30A and 30B (the ceiling surface of the first magnetic body 30A and the bottom surface of the second magnetic body 30B) is disposed with an opening hole 31 of the same shape. The hole 31 contains an intersection point between a line passing through the magnetic sensitive surface P of the Hall IC 20 and the first and second magnetic bodies 30A and 30B, where the line passing through the magnetic sensitive surface P is substantially perpendicular to a plane passing through the air gaps at the both end edges of the first and second magnetic bodies 30A and 30B.

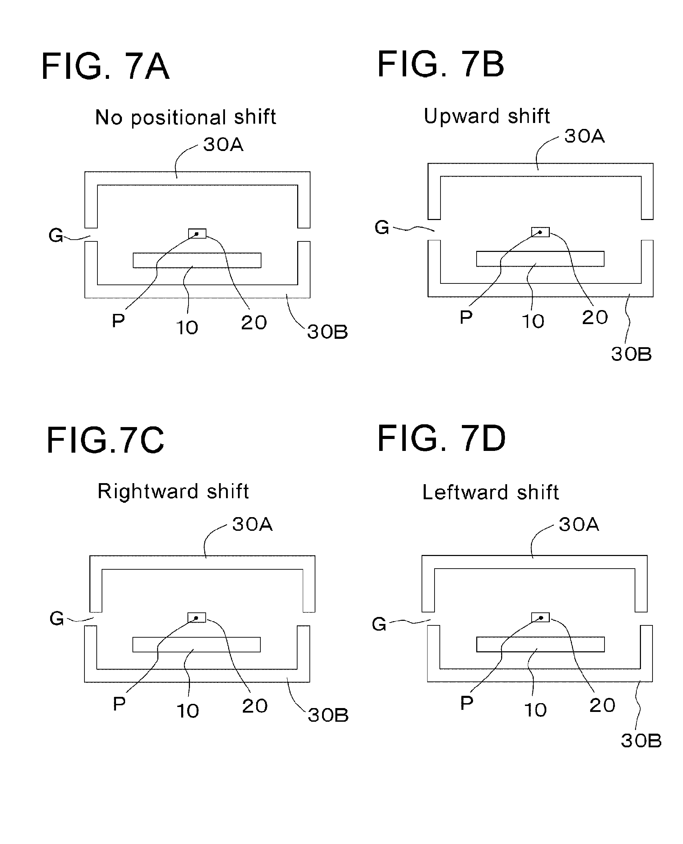

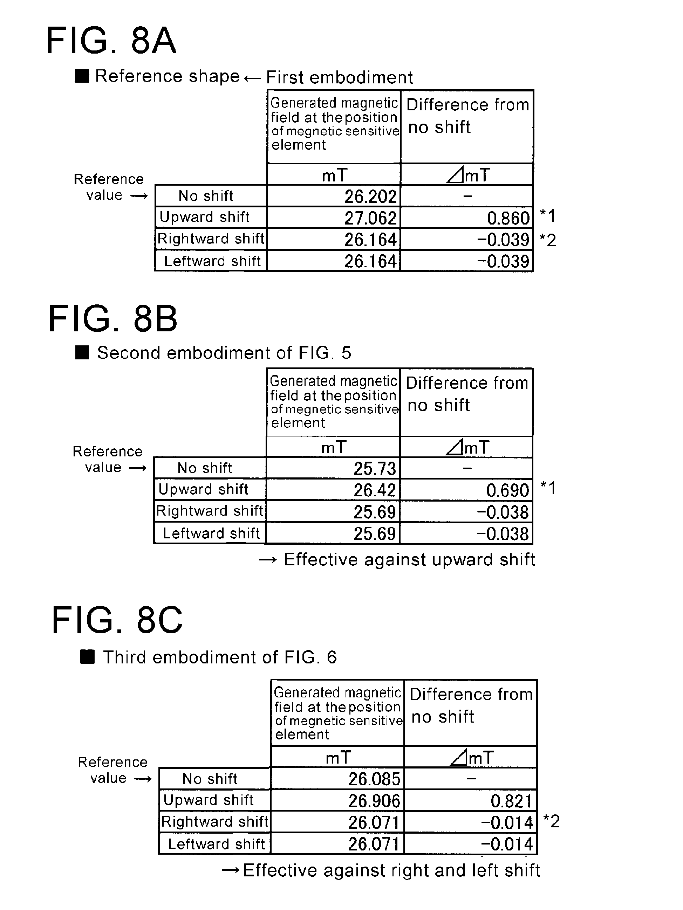

Since magnetic body portions opposed across the Hall IC 20 in the up-and-down direction are removed as the opening holes 31 in the case of the second embodiment of FIG. 5, the effect of magnetic fields exerted from the magnetic body portions facing the Hall IC 20 squarely in the up-and-down direction is reduced and, as a result, fluctuations are suppressed in a generated magnetic field at the position of the magnetic sensitive surface of the Hall IC 20 due to upward and downward positional shifts of the first and second magnetic bodies 30A and 30B from each other. This will be described with reference to FIGS. 7A and 7B and FIGS. 8A and 8B.

FIG. 7A to FIG. 7D show the presence of a positional shift between the first and second magnetic bodies 30A and 30B in the embodiments and FIGS. 7A, 7B, 7C, and 7D are front cross-sectional views when both have no positional shift, when the first magnetic body 30A is positionally shifted upward, when the first magnetic body 30A is positionally shifted to the right, and when the first magnetic body 30A is positionally shifted to the left, respectively. FIG. 8A to FIG. 8C show that the presence of a positional shift varies a generated magnetic field (mT) at the position of the magnetic sensitive surface of the Hall IC acting as a magnetic sensitive element while a current flows through the bus bar in the embodiments. FIGS. 8A, 8B, and 8C are explanatory views (tables) in the case of the first embodiment, in the case of the second embodiment, and in the case of the third embodiment, respectively.

If the second embedment of FIG. 5 causes an upward shift as shown in FIG. 7B, a difference ΔmT between no shift and upward shift is 0.690 as shown in FIG. 8B, and it can be seen that the difference is reduced from the difference ΔmT of 0.860 between no shift and upward shift of FIG. 8A in the first embodiment without the opening holes 31 (see *1). Weight saving can also be achieved by disposing the opening holes 31.

Although the case of the rectangular opening holes 31 is shown in the second embodiment of FIG. 5, the shape of the opening holes 31 may be any shape such as circle, ellipse, and oval. However, the shape does not reach the edges of the magnetic bodies 30A and 30B.

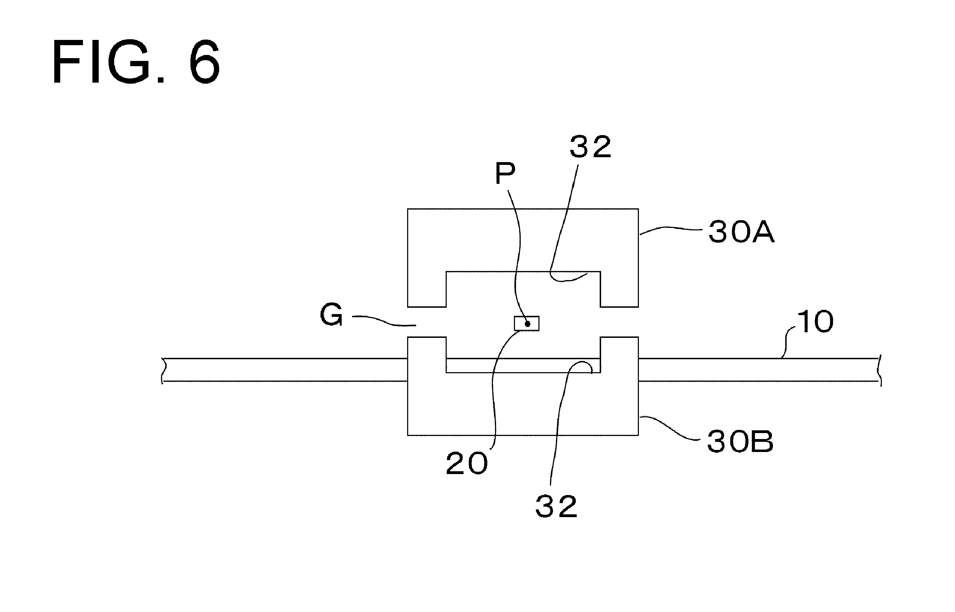

FIG. 6 shows a third embodiment of the present invention. In this case, the positional relationship of the bas bar 10, the Hall IC 20 acting as a magnetic sensitive element, and the first and second U-shaped cross-sectional magnetic bodies 30A and 30B is the same as the first embodiment; however, cutout portions 32 are formed in a symmetrical shape in intermediate portions of the both end edges (edges of side surfaces opposed to each other) of the first and second magnetic bodies 30A and 30B opposed to each other via the air gaps G.

Since magnetic body portions opposing across the Hall IC 20 in the width direction are removed as the cutout portions 32 in the case of the third embodiment of FIG. 6, the effect of magnetic fields exerted from the magnetic body portions facing the Hall IC 20 squarely in the width direction is reduced and, as a result, fluctuations are suppressed in a generated magnetic field at the position of the magnetic sensitive surface of the Hall IC 20 due to leftward and rightward (lateral) positional shifts of the first and second magnetic bodies 30A and 30B from each other. This will be described with reference to FIGS. 7A to 7D and FIGS. 8A to 8C.

If the third embedment of FIG. 6 causes a lateral shift to the right or left as shown in FIGS. 7C and 7D, a difference ΔmT between no shift and rightward shift (or leftward shift) is -0.014 as shown in FIG. 8C and it can be seen that the difference is reduced from the difference ΔmT of -0.039 between no shift and rightward shift (or leftward shift) of FIG. 8A in the first embodiment without the cutout portions 32 (see *2). Weight saving can also be achieved by disposing the cutout portions 32.

Although the case of the cutout portions 32 cur out into a rectangular shape is shown in the third embodiment of FIG. 6, the shape of the cutout portions 32 may be cut out into any shape such as half circle, half ellipse, and half oval. However, the shape does not reach the left and right ends of the magnetic bodies 30A and 30B.

FIG. 9A to FIG. 9D show a fourth embodiment of the present invention. FIG. 9A is a front cross-sectional view when the magnetic sensitive surface P of the Hall IC 20 acting as the magnetic sensitive element is located on a straight line connecting the opposed surfaces at both end edges of the first and second magnetic bodies 30A and 30B for magnetic shielding; FIG. 9B is a front cross-sectional view of the upper limit position when the Hall IC 20 is located on the straight line connecting the opposed surfaces at both end edges of the first and second magnetic bodies 30A and 30B; and FIG. 9C is a front cross-sectional view of the lower limit. As compared to the first embodiment shown in FIG. 1A to 1C etc., the current sensor of this embodiment is different in that the air gap G does not exist between the leading end surfaces (both end edges) of the pair of the first and second magnetic bodies 30A and 30B (the both end edges are in contact with each other) and the other points are the same. This embodiment can produce substantially the same effect as the first embodiment. Even when the air gap G does not exist, if the first and second magnetic bodies 30A and 30B are separated (not integrated), the magnetic resistance of the boundary between the both magnetic bodies is large and produces the effect of reducing the hysteresis of detected output of the current sensor. Therefore, it is important to dispose the magnetic sensitive element at a position at which a magnetic field applied to the magnetic sensitive element is weakened by the magnetic field generated by magnetization of the first magnetic body 30A and the magnetic field generated by magnetization of the second magnetic body 30B, regardless of the presence of the air gap G. FIGS. 9B and 9C show arrangements of embodiments pursuant to FIG. 9A, i.e., the arrangements of the bus bar 10 and the Hall IC 20 capable of sufficiently suppressing the effect of the residual magnetic field. In this case, the lower surface of the Hall IC 20 (outer shape) is located on the straight line connecting the opposed surfaces of the both end edges of the first and second magnetic bodies (FIG. 9B) or the upper surface of the Hall IC 20 (outer shape) is located on the straight line connecting the opposed surfaces of the both end edges of the first and second magnetic bodies (FIG. 9C). Even in the arrangements of the Hall IC 20 shown in FIGS. 9B and 9C, the magnetic field generated by magnetization of the magnetic body 30A and the magnetic field generated by magnetization of the magnetic body 30B are directed to cancel each other and, therefore, the effect of the residual magnetic field can sufficiently be suppressed. FIG. 9D is a diagram of a preferable disposition range W of the Hall IC 20.

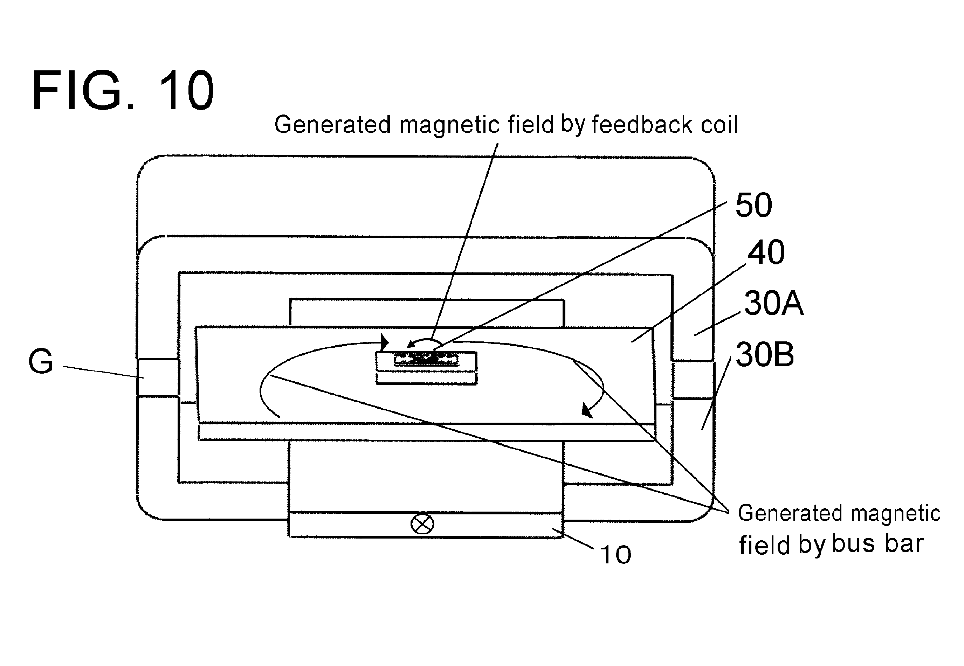

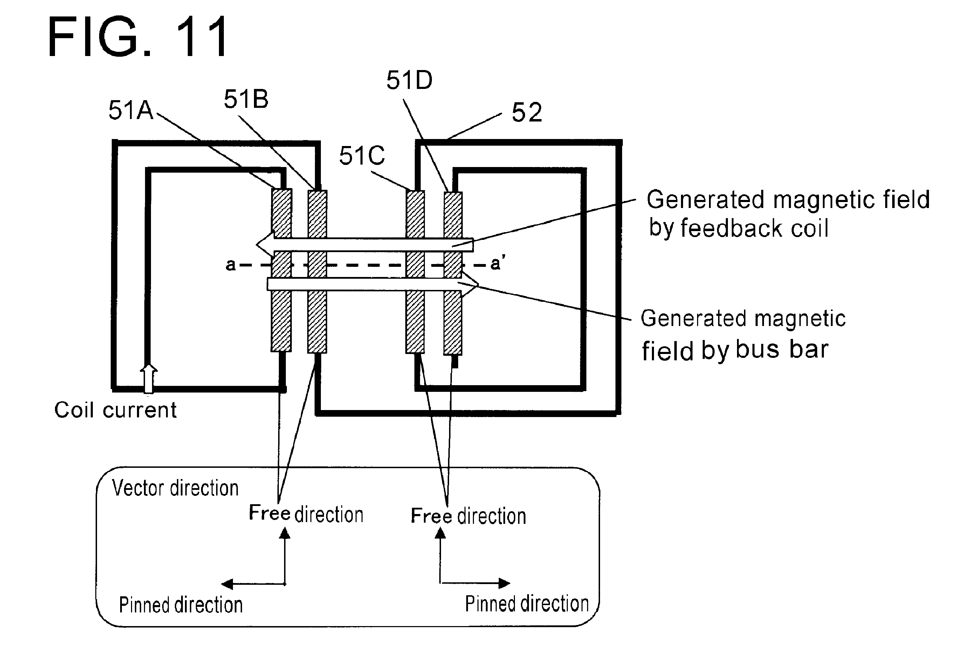

FIG. 10 is a general view of a fifth embodiment of the present invention when a magnetic balance type current sensor is constructed, and an MR element bridge 50 with feedback coil (hereinafter referred to as "MR package 50") shown in FIG. 11 is used instead of the Hall IC 20 fixedly disposed via the insulating substrate 40 on the bus bar 10. The positional relationship of the bus bar 10, the insulating substrate 40, and the MR package 50 to the magnetic bodies 30A and 30B is the same as the first embodiment.

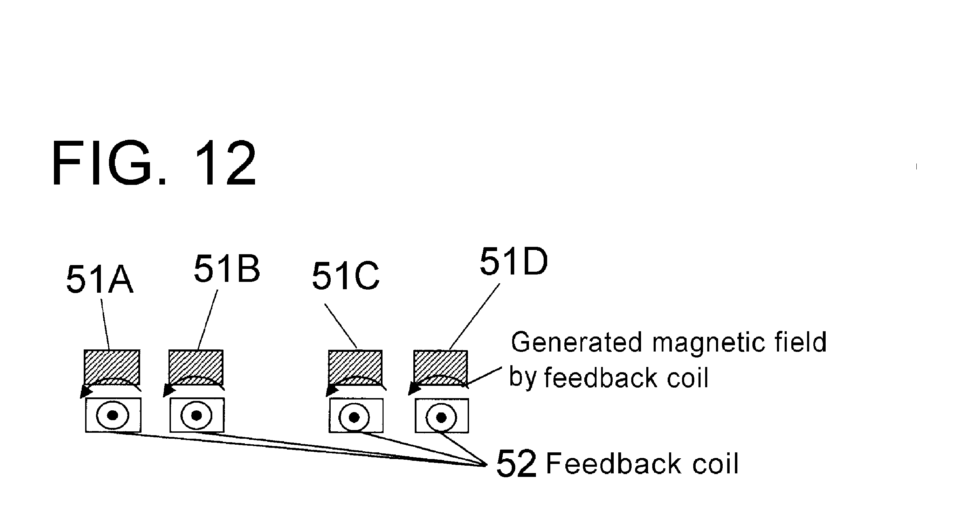

FIG. 11 shows an internal configuration of the MR package 50, which includes four spin-valve type MR elements 51A, 51B, 51C, and 51D arranged in parallel and a feedback coil 52. Free and pinned vector directions of the MR elements 51A, 51B, 51C, and 51D are as shown. The feedback coil 52 is disposed to overlap with the four spin-valve type MR elements 51A, 51B, 51C, and 51D arranged in parallel. Therefore, the feedback coil 52 is disposed along the free direction of the MR elements 51A, 51B, 51C, and 51D and, as shown in FIG. 12, the generated magnetic field by the feedback coil 52 is in the pinned direction (orthogonal to the free direction) of the MR elements 51A, 51B, 51C, and 51D and is applied to the MR elements 51A and 51B in the forward direction and to the MR elements 51C and 51D in the backward direction.

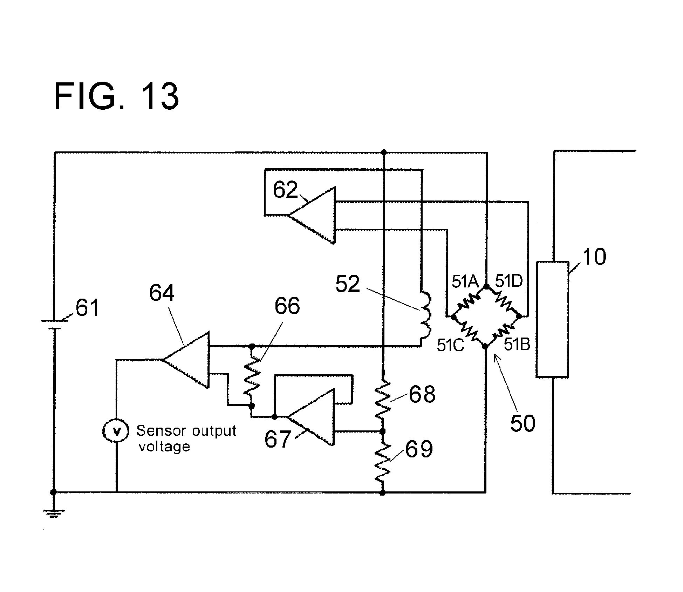

FIG. 13 shows a circuit configuration for acquiring the sensor detection output on the principle of the magnetic balance system. As shown in FIG. 13, the four MR elements 51A to 51D are full-bridge-connected between the high voltage side and the low voltage side of a power source 61. An interconnection point of the MR elements 51A and 51C and an interconnection point of the MR elements 51D and 51B are connected to respective input terminals of a differential amplifier 62 for negative feedback. To an output terminal of the differential amplifier 62 for negative feedback, the feedback coil 52 and a detecting resistor 66 are connected in series. An operating amplifier 67 and dividing resistors 68 and 69 dividing a power source voltage make up a buffer for stabilizing an intermediate voltage divided from the power source voltage and the intermediate voltage at an output end of the operating amplifier 67 is applied to one input terminal of an output differential amplifier 64. The both terminals of the detecting resistor 66 are respectively connected to the both input terminals of the output differential amplifier 64. The feedback coil 52 is formed as, for example, a conductive pattern on an element substrate in the vicinity of the MR elements 51A, 51B, 51C, and 51D as shown in FIGS. 11 and 12.

When the bus bar 10 carries a current, a magnetic field is applied to the MR elements 51A, 51B, 51C, and 51D. Due to the effect of the differential amplifier 62 for negative feedback, a feedback current flows through the feedback coil 52 such that a potential difference between the interconnection point of the MR elements 51A and 51C and the interconnection point of the MR elements 51D and 51B turns to zero, i.e., such that the generated magnetic field by the feedback coil 52 cancels the generated magnetic field by the bas bar 10 to turn the magnetic field applied to the MR elements 51A, 51B, 51C, and 51D to zero. Since the feedback current is in proportion to a measured current, a magnitude of the measured current can be identified from a sensor output voltage that is an amplified output of the output differential amplifier 64 amplifying a voltage into which the feedback current is converted by the detecting resistor 66.

Although the present invention has been described by taking the embodiments as examples, it is understood by those skilled in the art that the constituent elements and processing processes of the embodiments can variously be modified within the scope of claims. Modifications will hereinafter be mentioned.

Although the two magnetic bodies 30A and 30B opposed to each other are made of the same material having the same coercive force in the embodiments, the same effect can be acquired if the coercive forces are close to each other. Although the cross sections of the first and second magnetic bodies have the same shapes in the description, the same effect can be acquired even if the shapes are similar to each other.

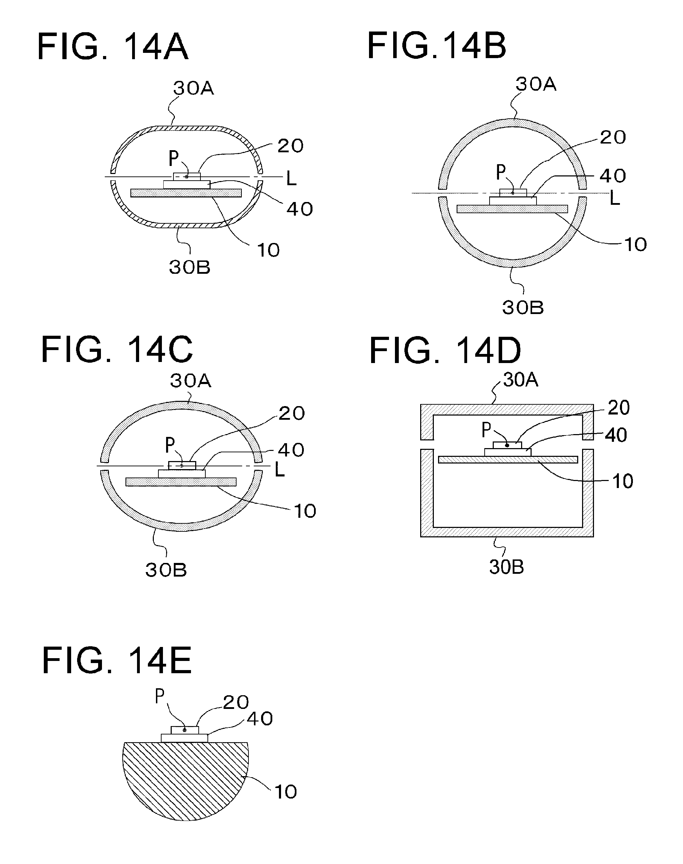

Although the shape of each of the two magnetic bodies 30A and 30B opposed to each other is a half rectangular tube shape in the embodiments, the shape of each of the two magnetic bodies 30A and 30B opposed to each other may be a half elliptic tube shape, a half cylindrical shape, or a half oval shape in modifications as shown in FIGS. 14A to 14C. Although FIGS. 14A to 14C show the case that the position of the magnetic sensitive surface P of the Hall IC 20 is located on the straight line L connecting the midpoints of the air gap length at the both end edges of the magnetic bodies 30A and 30B, the relationship of the position of the magnetic sensitive surface P and the air gap G may be the same as FIG. 1B. The shape of the two magnetic bodies 30A and 30B opposed to each other may not be a symmetrical shape given that the arrangement weakens the residual magnetic field at the magnetic sensitive surface P of the Hall IC 20 and the two magnetic bodies 30A and 30B opposed to each other may have different cross sections (may have an asymmetrical shape) as shown in FIG. 14D.

Although the shape of the bus bar 10 is a flat-plate shape in the embodiments, a bus bar having a rectangular, circular, or oval cross section may be employed in modifications. In the case of a circular or oval shape, a portion disposed with the insulating substrate 40 and the Hall IC 20 may be processed into a flat surface as shown in FIG. 14E.

Although the magnetic sensitive element is exemplary illustrated as a Hall IC in the embodiments, a Hall element, an MR element, a GMR element, etc., are also applicable.

## Claims

1. A current sensor comprising:
first and second magnetic bodies for magnetic shielding opposed to each other; and
a bus bar and a magnetic sensitive element disposed between the first and second magnetic bodies, wherein
the first and second magnetic bodies are magnetized in directions opposite to each other when a current flows through the bus bar, and wherein
the magnetic sensitive element is disposed at a position at which a magnetic field applied to the magnetic sensitive element is weakened by a magnetic field generated by magnetization of the first magnetic body and a magnetic field generated by magnetization of the second magnetic body.

2. The current sensor according to claim 1, wherein coercive forces of the first and second magnetic bodies are equivalent or close to each other.

3. The current sensor according to claim 1, wherein cross sections of the first and second magnetic bodies have the same or similar shapes.

4. The current sensor according to claim 1, wherein cross sections of the first and second magnetic bodies have asymmetrical shapes.

5. The current sensor according to claim 1, wherein the both end edges of the first and second magnetic bodies are opposed to each other through respective gaps, wherein the first and second magnetic bodies surround the bus bar and the magnetic sensitive element inside as a whole, and wherein
the magnetic sensitive element is located between a first straight line connecting the both end edges of the first magnetic body and a second straight line connecting the both end edges of the second magnetic body or located on the first or second straight line.

6. The current sensor according to claim 5, wherein a magnetic sensitive surface of the magnetic sensitive element is located between the first straight line and the second straight line.

7. The current sensor according to claim 5, wherein a magnetic sensitive surface of the magnetic sensitive element is located on, or in the vicinity of, a straight line connecting midpoints of a gap length at the both end edges of the first and second magnetic bodies.

8. The current sensor according to claim 5, wherein the bus bar is in a flat-plate shape having a wide principal surface that is parallel to the straight line, and the magnetic sensitive element is fixedly disposed on the wide principal surface.

9. The current sensor according to claim 5, wherein each of the first and second magnetic bodies is disposed with an opening hole containing an intersection point between the first and second magnetic bodies and a line that is substantially perpendicular to a plane passing through the gaps at the both end edges of the first and second magnetic bodies and that passes through the magnetic sensitive element.

10. The current sensor according to claim 5, wherein a cutout portion is disposed in each of intermediate portions of the both end edges of the first and second magnetic bodies opposed to each other through the gaps.

11. The current sensor according to claim 1, wherein the both end edges of the first and second magnetic bodies are opposed to each other, wherein the first and second magnetic bodies surround the bus bar and the magnetic sensitive element inside as a whole, and wherein
the magnetic sensitive element is located on a straight line connecting the opposed surfaces of the both end edges of the first magnetic body and the both end edges of the second magnetic body.

12. The current sensor according to claim 11, wherein a magnetic sensitive surface of the magnetic sensitive element is located on, or in the vicinity of, a straight line connecting the opposed surfaces of the both end edges of the first and second magnetic bodies.

13. The current sensor according to claim 11, wherein the bus bar is in a flat-plate shape having a wide principal surface that is parallel to the straight line, and wherein the magnetic sensitive element is fixedly disposed on the wide principal surface.

14. The current sensor according to claim 11, wherein each of the first and second magnetic bodies is disposed with an opening hole containing an intersection point between the first and second magnetic bodies and a line that is substantially perpendicular to a plane passing through the opposed surfaces of the both end edges of the first and second magnetic bodies and that passes through the magnetic sensitive element.

15. The current sensor according to claim 11, wherein a cutout portion is disposed in each of intermediate portions of the both end edges of the first and second magnetic bodies opposed to each other.

16. The current sensor according to claim 1, wherein the shape of the magnetic bodies is a half rectangular tube shape, a half elliptic tube shape, a half cylindrical shape, or a half oval shape.

17. The current sensor according to claim 1, wherein the current sensor is disposed with a feedback coil generating a magnetic field canceling a generated magnetic field due to a current of the bus bar.
